Europäisches Patentamt

European Patent Office

Office européen des brevets

(19)

(11) Veröffentlichungsnummer : **0 373 399 B1**

## (12) EUROPÄISCHE PATENTSCHRIFT

(45) Veröffentlichungstag der Patentschrift :
**04.01.95 Patentblatt 95/01**

(51) Int. Cl.$^6$ : **H01J 37/153, H01J 37/04**

(21) Anmeldenummer : **89121640.0**

(22) Anmeldetag : **23.11.89**

(54) Abbildender Korrektor vom Wien-Typ für Elektronenmikroskope.

(30) Priorität : **10.12.88 DE 3841715**

(43) Veröffentlichungstag der Anmeldung :
**20.06.90 Patentblatt 90/25**

(45) Bekanntmachung des Hinweises auf die
Patenterteilung :
**04.01.95 Patentblatt 95/01**

(84) Benannte Vertragsstaaten :
**DE FR GB IT NL**

(56) Entgegenhaltungen :
**EP-A- 0 231 164**
**US-A- 4 389 571**

(56) Entgegenhaltungen :
**OPTIK. vol. 77, no. 1, 1987, STUTTGART DE**
**Seiten 26 - 34; H. Rose: "The retarding Wien**
**filter as a high-performance imaging filter."**
**NUCLEAR INSTRUMENTS AND METHODS.**
**vol. 187, 1981, AMSTERDAM,NL, Seiten**
**187-199; H. Rose: "Correction of aperture**
**aberrations in magnetic systems with three-**
**fold symmetry"**

(73) Patentinhaber : **Firma Carl Zeiss**
**D-73446 Oberkochen (DE)**
(84) **DE FR IT NL**
Patentinhaber : **CARL ZEISS-STIFTUNG**
**HANDELND ALS CARL ZEISS**
**D-89518 Heidenheim (Brenz) (DE)**
(84) **GB**

(72) Erfinder : **Rose, Harald, Prof. Dr.**
**Prinz-Christians-Weg 5 1/2**
**D-6100 Darmstadt (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 373 399 B1

## Beschreibung

Die vorliegende Erfindung betrifft einen abbildenden Korrektor vom Wien-Typ für Elektronenmikroskope mit einer mindestens achtzähligen Anordnung der Elektroden und magnetischen Polen, die zur Erzeugung elektrischer und magnetischer Korrekturfelder dienen, mit mindestens einer Objektiv- und einer Bildübertragungslinse, wobei der Korrektor zwischen einer Objektiv- und einer Bildübertragungslinse angeordnet ist.

Gemäß dem Scherzer Theorem ist die Vermeidung der axialen chromatischen und sphärischen Aberration bei rotationssymmetrischen Elektronenlinsen nicht möglich. Bei Spannungen größer als 50 kV dominiert die Aperturaberration und begrenzt die Auflösung von Elektronenmikroskopen und Mikrosonden.

Insbesondere bei Potentialspannungen kleiner als 5 kV zwischen der Quelle und der Objektebene begrenzt die chromatische Aberration die Auflösung in entscheidender Weise, Diese Niedervolt-Elektronenmikroskopie wird zur Kontrolle von Mikroschaltkreisen, der direkten Untersuchung der Oberflächen von Nichtleitern, biologischen Objekten sowie Halbleitern mit hoher räumlicher Auflösung bevorzugt eingesetzt.

Die Begrenzung durch die chromatische Aberration resultiert aus der Tatsache, daß die Eindringtiefe der auftreffenden Elektronen auf das Objekt sich auf nur wenige Atomlagen bei Beschleunigungsspannungen zwischen 30 und $10^3$ V beläuft. Dies führt dazu, daß die Auflösung im wesentlichen durch den Durchmesser der Elektronensonde begrenzt ist und nicht durch die Austrittstiefe der Sekundärelektronen.

Die Wellenlänge der auftreffenden Elektronen ist bedeutend kleiner als die erreichbare Auflösung. Eine grobe Abschätzung ergibt, daß überwiegend der chromatische Fehler auflösungsbegrenzend ist und für eine Auflösung von 1 nm bei 1 kV sowohl die sphärische als auch die chromatische Aberration eliminiert werden müssen.

Bisher bieten die elektrischen und magnetischen Oktupolkorrekturen die einzige Möglichkeit zur simultanen Korrektur der axialen chromatischen und sphärischen Aberration (H. Rose, Optik 33 (1971), S.l ff und H. Rose, Optik 34 (1971), S 285 ff). Leider bestehen diese bekannten Systeme aus vielen Elementen, welche schwer zu justieren sind. Außerdem sind sie sehr empfindlich gegenüber mechanischen Vibrationen und den Veränderungen der individuellen Quadrupolfelder. Trotzdem konnte gezeigt werden, daß diese Filter in der Lage sind, Elektronenlinsen zu korrigieren (H. Koops, Optik 52 (1978/79), S. l ff und W. Bernhard, Optik 57 (1980), S. 73 ff).

Um die Anzahl der Korrekturelemente zu verkleinern und somit die Justierung zu vereinfachen, ist es sehr hilfreich, wenn der paraxiale Strahlengang innerhalb des Korrektors rotations-sysmmetrisch gestaltet wird. Dies ist zum Beispiel der Fall in Systemen, die aus runden Linsen und Sextupolen bestehen. Diese können hinsichtlich der sphärischen Aberration korrigiert werden (V. Beck, Optik 53 (1979), S. 241 ff und H. Rose, Nucl. Instr. Meth. 187 (1981), S. 187 ff). In diesem Fall wird die sphärische Aberration von runden Linsen durch eine kombinierte Aberration von zwei räumlich getrennten Sextupolen kompensiert. Das von Herrn Rose vorgeschlagene System hat keine Fehler zweiter und vierter Ordnung und eignet sich deshalb auch als Korrektor für das Ruhbild-Transmissions-Elektronenmikroskop. Leider können diese Systeme nicht zur Korrektur der axialen chromatischen Aberration verwendet werden.

Ein inhomogenes Wien-Filter, welches für alle geometrischen Aberrationen zweiter Ordnung korrigiert ist, wurde bereits vorgeschlagen (H. Rose, Optik 77 (1987), S. 26 ff). Neben einer hohen Dispersion hat dieses Filter eine axiale chromatische Aberration, welche leider dasselbe Vorzeichen hat wie die einer Rundlinse. Ein derartiges Filter kann daher nicht zur Korrektur der axialen chromatischen Aberration herangezogen werden.

Der vorliegenden Erfindung liegt daher die Aufgabe zugrunde, einen abbildenden Korrektor zu schaffen, der die axiale chromatische Aberration eines abbildenden Gesamtsystems, vorzugsweise in Elektronenmikroskopen, eliminiert.

Die gestellte Aufgabe wird erfindungsgemäß durch die Merkmale des Anspruches 1 gelöst.

Der Korrektor beginnt und endet im eingebauten Zustand an einer Zwischenbildebene, hat eine weitere Zwischenbildebene in seiner Mitte und in den Korrektor parallel zur optischen Achse einfallende Strahlen verlaufen bezüglich der mittleren Zwischenbildebene spiegelsymmetrisch, schneiden die optische Achse jeweils zwischen zwei Zwischenbildebenen und haben an den Schnittpunkten einen punktsymmetrischen Verlauf innerhalb einer Korrektorhälfte bezogen zur optischen Achse.

Mit diesem abbildenden Korrektor vom Wien-Typ mit 1:1 Abbildungseigenschaft ist es generell möglich, eine Korrektur der chromatischen Aberration zu erzielen. Außerdem ist eine gleichzeitige Korrektur der sphärischen Aberration für Elektronen mit einer bestimmten Nominalenergie möglich. Diese Energie hängt ab von den Parametern des Korrektors und dem Verhältnis der Potentiale von Objekt und Korrektor.

Der Korrektor ist nichtdispersiv und doppelfokussierend, so daß keine chromatischen Aberrationen nullter Ordnung in der Bildebene auftreten. Da sowohl der Eintritt der Elektronen in als auch ihr Austritt aus dem Korrektor an einer Zwischenbildebene erfolgt, beeinträchtigen die Randfelder nicht die Abbildung.

Aufgrund der doppelten Symmetrie der paraxialen Bahnen innerhalb des Korrektors verschwinden alle

2

geometrischen Aberrationen gerader Ordnung. Außerdem sorgt die Doppelsymmetrie im Korrektor dafür, daß keine außeraxialen chromatischen Aberrationen und keine Dispersion 2. Grades in der Bildebene durch den Korrektor erzeugt werden. Gleichzeitig tritt bei diesem Korrektor kein Koma dritter Ordnung auf. Daraus resultiert eine signifikante Verbesserung der Auflösung außeraxialer Punkte. Dieser inhomogene Korrektor vom Wien-Typ eignet sich daher sowohl für Rasterelektronenmikroskope, insbesondere Niedervolt-Rasterelektronenmikroskope als auch für Emissionsmikroskope.

Durch die kompakte Bauweise des Korrektors als ein Bauteil ist eine leichte Justierung zwischen den Elektronenlinsen sichergestellt. Die Anforderungen an die relative Stabilität der elektrischen und magnetischen Dipol- und Quadrupolströme mit $10^6$ für 1 nm bei 1 kV ist geringer als bei anderen Systemen, wodurch eine gute technische Beherrschbarkeit vorhanden ist. Die Sextupol- und Oktupolbeschaltungen erfordern eine weitaus geringere Stabilität der elektrischen Versorgung als bisher in Elektronenmikroskopen notwendig.

Damit die notwendigen Aperturen vor der Korrektur nicht zu groß werden, muß der Korrektor zwischen der Objektiv- und der ersten Bildübertragungslinse angeordnet werden. Dabei sollte die Zwischenvergrößerung M des Bildes in der Eintrittsebene $Z_1$ des Korrektors im Bereich $1 \leqq M \leqq 2$ liegen.

Um auch eine Korrektur der sphärischen Aberration für diejenigen Elektronen durchführen zu können, deren Energie von der Nominalenergie abweicht, ist es vorteilhaft, ein zusätzliches Korrektionsfilter mit elektrischen und magnetischen Quadrupolfeldern hinter der dem Korrektor vom Wien-Typ in Strahlenrichtung folgenden Elektronenlinse anzubringen. Diese Anbringung ist insbesondere in der hinteren Brennebene dieser Elektronenlinse vorteilhaft, weil dann kein Vergrößerungsfarbfehler entsteht.

Die Korrektur des Öffnungsfehlers mit zusätzlichen elektrischen und magnetischen Sextupolfeldern innerhalb des Korrektors erzeugt einen axialen, chromatischen Astigmatismus. Dieser wird durch die hinzugekommenen elektrischen und magnetischen Quadrupolfelder kompensiert, wobei das Element um den Brennpunkt der Bildübertragungslinse angeordnet wird, so daß keine außeraxialen Fehler das Korrektionsergebnis verschlechtern.

Da bei Niedervolt-Elektronenmikroskopen mit Potentialen zwischen 0,5 und 5 kV (bezogen auf die Quelle mit dem Potential Null) in erster Linie die chromatischen Aberrationen auflösungsbegrenzend wirken, ist hier die Verwendung des nichtdispersiven Korrektors vom Wien-Typ wegen seiner Einfachheit am vorteilhaftesten.

Durch die Baugröße des Korrektors werden die benötigten Feldstärken und elektrischen Versorgungen festgelegt. Um die Versorgungsspannungen, -ströme und Feldstärken in beherrschbaren Grenzen zu halten, ohne gleichzeitig die mechanischen Fertigungstoleranzen zu stark zu verringern, sollte die Baulänge des Filters zwischen 40 und 60 Millimetern bei Bohrungsradien von 2-5 Millimetern liegen.

Die durch die Kompaktheit des Korrektors vom Wien-Typ gegebene leichte Justierbarkeit läßt sich durch eine von den anderen Feldern unabhängige Einstellung jedes einzelnen Multipolfeldes noch weiter unterstützen. Dabei werden alle Felder im Inneren des Korrektors erzeugt, d.h. sowohl die elektrischen als auch die magnetischen Multipolfelder.

Um den Korrektor leicht dimensionieren zu können und damit die Baugröße in Grenzen zu halten, erfolgt eine mathematische Vordimensionierung anhand von Korrektionsbedingungen für den Korrektor. Diese Vordimensionierung wird dann der jeweiligen Korrektorspezifikation zugrundegelegt. Zur Durchführung der Vordimensionierung können dabei die in der Anlage A genannten Formeln verwendet werden.

Benötigt man einen Korrektor, welcher sowohl in Raster- als auch in Transmissionselektronenmikroskopen den chromatischen Fehler und den Öffnungsfehler für Elektronen beliebiger Energie korrigiert, so kann man anstelle eines Korrektors zwei Korrektoren einsetzen, zwischen welchen sich eine dicke teleskopische Rundlinse (realisierbar durch ein Rundlinsenduplett) befindet. Alternativ kann der Korrektor aber auch aus einem Korrektor vom Wien-Typ, zwei Transferlinsen und zwei als Hexapole betriebenen Multipolen bestehen.

Die Erfindung ist in den Zeichnungen dargestellt und wird im folgenden näher beschrieben.

Es zeigen,

Fig. 1     die erfindungsgemäße Anordnung des Korrektors zwischen zwei Elektronenlinsen eines Elektronenmikroskops in schematischer Darstellung;

Fig. 2     eine Aufsicht auf einen Korrektor als Oktupol mit der Strom- und Spannungsversorgung;

Fig. 3     eine dreidimensionale Ansicht von Fig. 2;

Fig. 4     eine Korrektionsanordnung für ein Transmissionselektronenmikroskop;

Fig. 5     eine alternative Korrektionsanordnung zu Fig. 4.

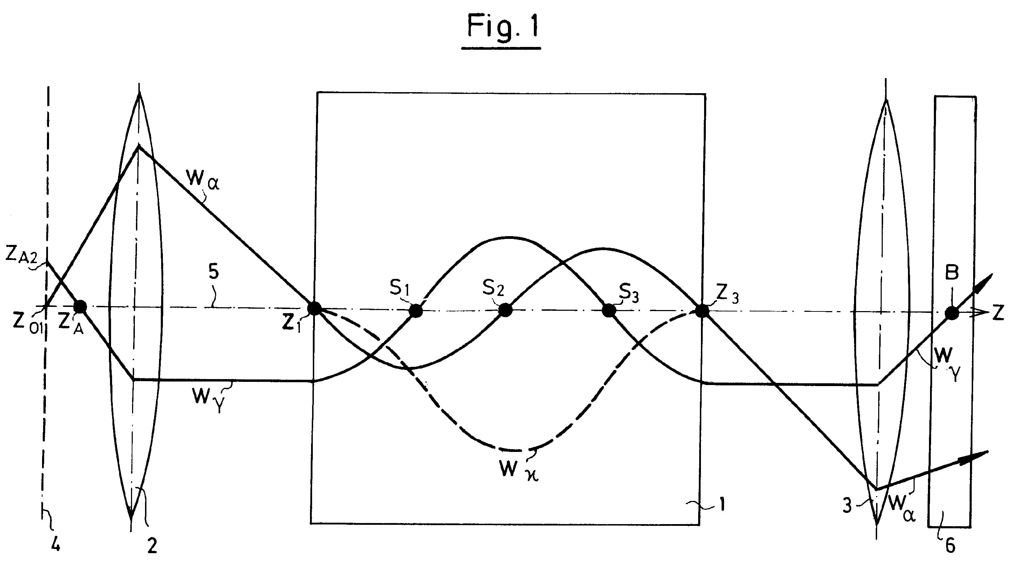

Der in der Figur 1 gezeigte Korrektor vom Wien-Typ (1), der zwischen einer Objektiv- (2) und einer Bildübertragungslinse (3) angebracht ist, korrigiert mittels seiner Kombinationsfehler sowohl die chromatische als auch die sphärische Aberration für Elektronen mit Nominalenergie. Dabei versteht man unter Kombinationsfehler eines Korrektors (1) bewußt erzeugte Fehler, welche den Elektronen beim Durchgang durch den Korrektor (1) aufgeprägt werden, wobei die Fehler den selben Betrag, jedoch ein umgekehrtes Vorzeichen haben wie die Fehler, welche die Elektronen durch die zu korrigierenden Elektronenlinsen (2,3) erhalten. Das heißt, unter den Kombinationsfehlern sind sekundäre Aberrationen zu verstehen, welche aus der Kombination der primären Aberrationen von räumlich getrennten Elementen entsprechend sehr ausgedehnter "dicker" Linsen resultieren. Wenngleich die sekundären Aberrationen des Korrektors (1) vom Wien-Typ generell sehr viel geringer wirken als die primären Aberrationen, so werden sie doch nach der Beseitigung der primären Aberrationen dominant.

Die kombinierten Aberrationen können relativ groß gemacht werden, da sie proportional mit der Entfernung zwischen zwei beliebigen Elementen bzw. mit der Länge eines ausgedehnten Elements ansteigen. Im Gegensatz zu den primären Aberrationen kann das Vorzeichen der sekundären Aberrationen abhängig von der Bahn der paraxialen Strahlen innerhalb des Korrektors (1) positiv oder negativ gemacht werden, so daß mittels des Kombinationsfehlers die primären Aberrationen korrigiert werden können.

Die von der Objektebene (4) ausgehenden Elektronen werden durch die Objektivlinse (2), deren objektseitiger Brennpunkt ($Z_A$) zwischen der Linse und der Objektebene (4) liegt, auf den Korrektor (1) abgebildet. Dieser Korrektor (1) ist so in das abbildende System des Elektronenmikroskopes eingebaut, daß er in der ersten Zwischenbildebene ($Z_1$) nach der Objektivlinse (2) beginnt. Innerhalb des Korrektors (1) befinden sich drei Symmetrieebenen ($S_1$, $S_2$, $S_3$) senkrecht zur optischen Achse (5).

In der ersten und dritten Symmetrieebene ($S_1$, $S_3$) schneiden diejenigen Elektronen die optische Achse (5), welche in den Korrektor (1) parallel zur optischen Achse (5) eindringen.

Zwischen diesen beiden Symmetrieebenen ($S_1$, $S_3$) befindet sich in der Mitte des Korrektors (1) eine weitere Symmetrieebene ($S_2$). Diese Symmetrieebene ($S_2$) ist gleichzeitig eine Zwischenbildebene des elektronenoptischen Systems. An einer dritten Zwischenbildebene ($Z_3$), welche der Bildübertragungslinse (3) zugeordnet ist, endet der Korrektor (1).

Die Elektronen treten korrigiert aus dem Korrektor (1) aus, ohne daß außerhalb des Korrektors (1) eine Versetzung wirksam wird. Durch die nachfolgende Bildübertragungslinse (3) werden sie dann in die Bildebene (hier nicht mehr eingezeichnet) abgebildet. Hinter der Bildübertragungslinse (3) befindet sich ein zusätzlicher elektrischer und magnetischer Quadrupol (6) um den objektfernen Brennpunkt (B) der Bildübertragungslinse (3). Dieser elektrische und magnetische Quadrupol (6) dient zur Korrektur des chromatischen Astigmatismus. Er ist nur notwendig, wenn die Korrektur der sphärischen Aberration für beliebiges Objektpotential durchgeführt werden soll.

Zur Verdeutlichung der Funktion des in der Figur gezeigten Korrektors (1) zwischen einer Objektiv- (2) und einer Bildübertragungslinse (3) sind außerdem noch die drei Elektronenbahnen ($W\alpha$, $W_\gamma$ und $W_\chi$) eingezeichnet.

Die aus der Objektebene (4) an der optischen Achse (5) austretenden Elektronen (bei $Z_{01}$), welche in den Korrektor (1) auf dieser optischen Achse (5) eintreten, verlassen den Korrektor (1) auch wieder auf der optischen Achse (5). Innerhalb des Korrektors (1) verlassen die Elektronen zwar die optische Achse (5), um der Elektronenbahn $W_\chi$ zu folgen. Die Symmetriebedingungen des Korrektors (1) sind aber so ausgelegt, daß die Bahnabweichungen in der ersten Korrektorhälfte zwischen ($Z_1$) und ($S_2$) durch die Bahnabweichungen in der zweiten Korrektorhälfte zwischen ($S_2$) und ($Z_3$) vollständig kompensiert werden. Für diese Elektronen ist die mittlere Zwischenbildebene ($S_2$) eine Spiegelebene.

Die Wendepunkte der Elektronenbahn $W_\chi$ liegen dabei in den Symmetrieebenen ($S_1$ und $S_2$). Die Elektronenbahn $W_\chi$ ist proportional zum relativen Energieverlust $\Delta E/E_o$ der Elektronen. Axiale Elektronen mit der Sollenergie $E=E_o$ werden daher vom Korrektor nicht beeinflußt.

Verlassen die Elektronen hingegen die Objektebene (4) an deren Schnittpunkt ($Z_{01}$) mit der optischen Achse (5) des Elektronenmikroskops aber unter einem gewissen Winkel und folgen der Elektronenbahn ($W_\alpha$), so werden sie von der Objektivlinse (2) derart umgelenkt, daß sie die optische Achse (5) an der ersten Zwischenbildebene ($Z_1$) das erste Mal schneiden. Die Elektronen treten dann in den an dieser Zwischenbildebene ($Z_1$) beginnenden Korrektor (1) unter einem bestimmten Winkel ein. Durch die Symmetriebedingungen des Korrektors (1) erfahren die Elektronen, welche der Elektronenbahn ($W_\alpha$) folgen, an den Symmetrieebenen ($S_1$ und $S_3$) eine Spiegelung an einer Ebene, während sie an der mittleren Zwischenbildebene ($S_2$) eine Punktspiegelung erfahren. Sie treten dann aus dem Korrektor (1) unter dem Eintrittswinkel wieder aus dem Korrektor (1) aus, da der Korrektor (1) an einer Zwischenbildebene ($Z_3$) endet.

Außeraxial aus der Objektebene (4) austretende Elektronen, welche vom Punkt ($Z_{A2}$) der Elektronenbahn ($W_\gamma$) folgen und deren Bahn ($W_\gamma$) durch den objektseitigen Fokus ($Z_A$) der Objektivlinse (2) verlaufen, treten in den Korrektor (1) parallel zur optischen Achse (5) ein. Diese Elektronen schneiden die optische Achse (5) in den Symmetrieebenen ($S_1$ und $S_3$), wo sie eine Punktspiegelung erfahren. An der mittleren Symmetrieebene ($S_2$) erfahren sie hingegen eine Spiegelung an der Ebene.

Um einen Korrektor (1) der vorab beschriebenen Art bauen zu können, ist es hilfreich, die aus den verschiedenen Bedingungen resultierenden Größen vorab bestimmen zu können. Es besteht zwischen den Eigenschaften der kombinierten Aberrationen und denen der primären Aberrationen von Elementen mit rotati-

4

onssymmetrischen paraxialen Strahlen eine Verbindung. Die kombinierten Aberrationen haben die Ordnung $n = n_1 + n_2 - 1$ und die Zähligkeit $m = |m_1 \pm m_2| \leqq n + 1$, wenn man mit $n_1$, $n_2$ jeweils die Ordnungen und mit $m_1$, $m_2$ jeweils die Zähligkeit der primären Aberrationen bezeichnet.

Wenn die Strahlen um einen kleinen Betrag $\Delta$ von der optischen Achse des Korrektors (1) versetzt verlaufen, ist die Zähligkeit von jeder Multipolkomponente der elektrischen und magnetischen Felder um die Originalachse um 1 bezüglich der neuen Achse verringert. Der inhomogene Korrektor (1) vom Wien-Typ hat unter anderem eine Feldkomponente der Ordnung $n_1 = 2$ und der Zähligkeit $m_1 = 1$ in Bezug zur optischen Achse (5). Eine kleine Versetzung $\Delta$ von der Strahlenachse ($n_2 = 0$, $m_2 = 1$), welche proportional zu der relativen Energieabweichung $\chi = \Delta \phi / \phi = \Delta E/E$ eines Elektrons ist, resultiert in einer chromatischen Aberration der Ordnung $n = 2 - 0 - 1 = 1$ und der Zähligkeit $m = |1 \pm 1|$. Dabei differiert die Energie des Elektrons mit dem Betrag $E = e \Delta\phi$ von der nominalen Energie $E = m\, v^2/2 = e\, \phi$. Elektronen mit dieser Energie werden durch den Korrektor (1) nicht abgelenkt; $\phi$ ist das elektrische Potential auf der Achse (5) innerhalb des Korrektors (1) und mit e, m sowie v sind entsprechend der Reihenfolge die Ladung, die Masse und die axiale Geschwindigkeit des nichtabgelenkten Elektrons bezeichnet.

Der inhomogene Korrektor (1) hat gemäß dem vorher gesagten einen chromatischen Astigmatismus erster Ordnung ($m = 2$) und eine rotationssymmetrische chromatische Aberration ($m = 0$). Letztere wird zur Kompensation der axialen chromatischen Aberration der beiden runden Linsen (2,3) verwendet.

Da der Korrektor (1) in dem nichtdispersiven Mode betrieben wird, kann die axiale chromatische Aberration negativ gemacht werden. Dabei bewegen sich die Elektronen, welche sich ursprünglich längs der optischen Achse (5) bewegt haben, nach Durchgang durch den Korrektor (1) unabhängig von ihrer Energie wieder auf dieser Achse (5). Innerhalb des Korrektors (1) sind die Elektronenbahnen von dieser Achse (5) in Abhängigkeit von ihrer relativen Energieabweichung $\chi$ versetzt.

Da die Strahlen ($W\alpha$ und $W_\gamma$) zu wenigstens einer der Symmetrieebenen ($S_1$, $S_2$, $S_3$) antisymmetrisch verlaufen, verschwinden alle geometrischen Aberrationen zweiter Ordnung. Daher kann die elektrische Quadrupolkraft des Korrektors (1) als ein freier Parameter beliebig gewählt werden. Dies hat den Vorteil, daß die axiale chromatische Aberration des Korrektors (1) nicht festgelegt ist, sondern als Funktion der elektrischen Quadrupolstärke verändert werden kann. Der Effekt dieser Variation auf die paraxialen Elektronen mit nomineller Energie ($\chi = o$) wird durch eine passende Einstellung der magnetischen Quadrupolstärke kompensiert.

Die sich aus diesen Ausführungen ergebenden Bedingungen lassen sich in mathematische Zusammenhänge gemäß Anlage A zusammenfassen. Die sich dabei ergebenden elektrischen und magnetischen Felder können mit einem Multipol mit mindestens acht diskret elektrisch und magnetisch ansteuerbaren Polen erzeugt werden.

Mit 1) ist die Wien-Bedingung für gerade Achsen von Dipolen bezeichnet. Die Bedingung, daß der Korrektor vom Wien-Typ (1) nicht dispersiv ist, ist mit 2) gekennzeichnet. Mit der Bedingung 3) wird erreicht, daß der Korrektor (1) durchgehend frei von axialem Astigmatismus ist. Der Korrektor (1) verhält sich dann in paraxialer Näherung für Elektronen mit $\chi = o$ wie eine teleskopische Rundlinse. Die Bedingung 4) sorgt dafür, daß das System keinen chromatischen Astigmatismus besitzt. Durch die Bedingungen 5) und 6) wird erreicht, daß der Öffnungsfehler dritter Ordnung des Korrektors rotationssymmetrisch ist (Kompensation des vier- und des zweizähligen Anteils). Die Bedingung 7) ist notwendig zur Korrektur der chromatischen Aberration des Gesamtsystems. Mit der letzten Bedingung 8) erreicht man eine gleichzeitige Korrektur des Öffnungsfehlers. Falls der Öffnungsfehler grundsätzlich, d.h. auch für Elektronen nicht mit Nominalenergie, korrigiert werden soll, muß Bedingung 4) verlassen werden. Es entsteht dadurch ein axialer chromatischer Astigmatismus, der aber durch den zusätzlich in das elektronenoptische System aufgenommenen elektrischen und magnetischen Quadrupol (6) korrigiert werden kann. Damit bei dieser Kompensation keine außeraxialen Aberrationen entstehen, muß der Quadrupol (6) so angeordnet werden, daß in seiner Mitte ein Bild (B) der Brennebene ($Z_A$) der Objektivlinse liegt.

Die Dimensionen des Korrektors (1) sollten so bemessen sein, daß keine zu starken elektrischen und magnetischen Felder aufgebaut werden müssen. Dies ist zum Beispiel bei dem Korrektor (1) im Falle einer Baulänge von 50 mm und einem Bohrungsdurchmesser von 4 mm gegeben. Der Korrektor (1) muß gemessen zur Kathode auf einem Potential von ungefähr 5-10 kV liegen, damit die Stabilität der Felderzeugung gewährleistet werden kann.

Da nach der Korrektur des Öffnungsfehlers dritter Ordnung und des Farbfehlers ersten Grades durch den Korrektor (1) die Auflösung lediglich durch den Öffnungsfehler fünfter Ordnung und die chromatische Aberration erster Ordnung und zweiten Grades begrenzt wird, ergibt sich eine signifikante Erhöhung der Auflösung.

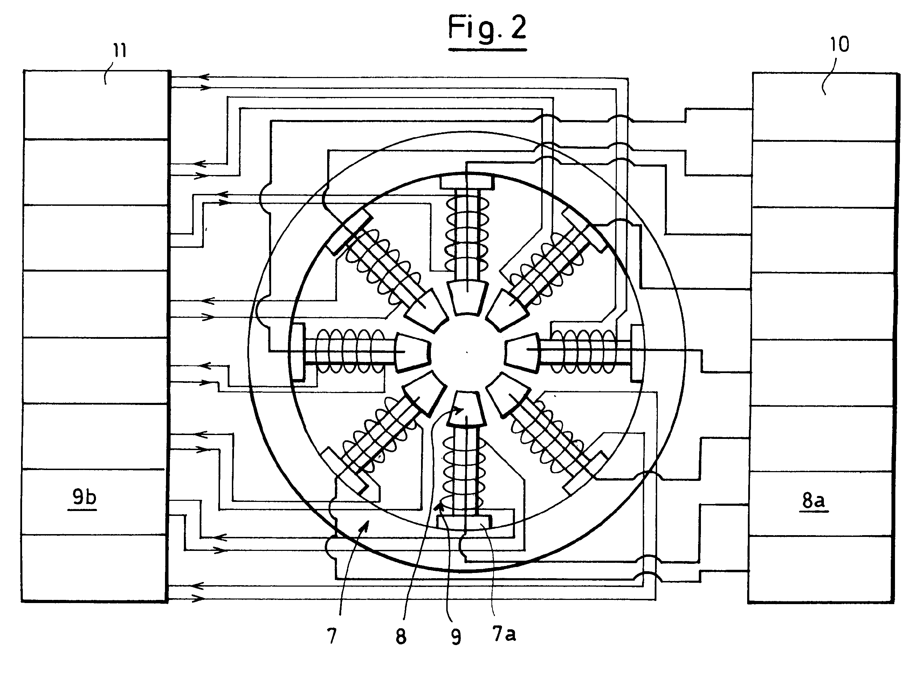

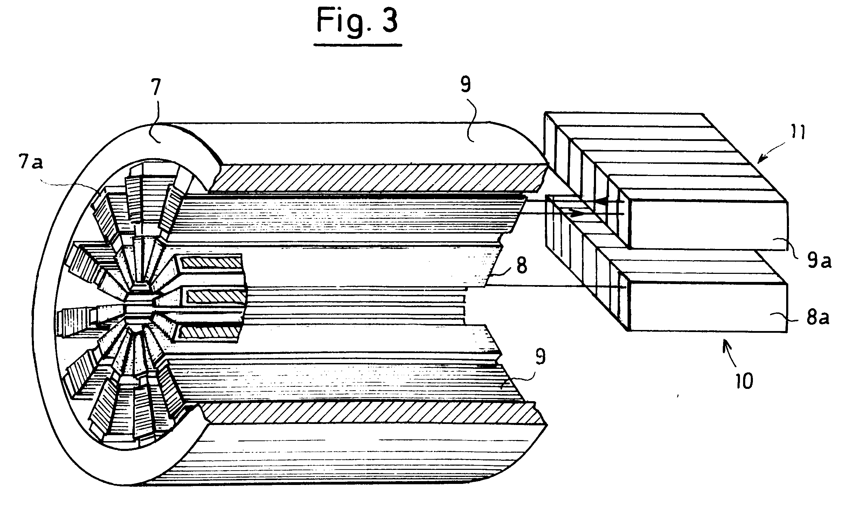

In Fig. 2 und Fig. 3 ist ein geeigneter Korrektor mit der Mindestanzahl von Polen gezeigt. Es handelt sich bei ihm um einen elektrischen und magnetischen Oktupol zur Erzeugung der jeweils vier für die Korrektion benötigten elektrischen und magnetischen Felder. Wichtig ist, daß jeder der Multipole elektrisch und magnetisch diskret und unabhängig von allen anderen Polen eingestellt werden kann. Dies erleichtert die Einstellung bei der Montage sehr. Jeder der acht Polkappen (8) und jede der acht Spulen (9) wird diskret von einer eigenen Strom- (9b) bzw. Spannungserzeugungseinrichtung (8a) versorgt. Die Pole sind in einem Ummantelungsring (7) kreisförmig in gleichen Abständen zueinander angeordnet. Die Polschuhe (7a) sorgen für eine Isolierung zu dem Ummantelungsring (7). Hinsichtlich der technologischen Voraussetzungen von Multipolsystemen sei insbesondere auf die beiden Veröffentlichungen "Technologische Voraussetzungen für die Verbesserung der Korrektur von Elektronenlinsen" (Optik 60 No. 3 (1982), S. 307-326) und "Design and test of an electric and magnetic dodecapole lens" (Optik 63, No. 1 (1982), S. 9-23) verwiesen. Als Trägermaterial eignet sich insbesondere eine leicht bearbeitbare und thermisch stabile Keramik.

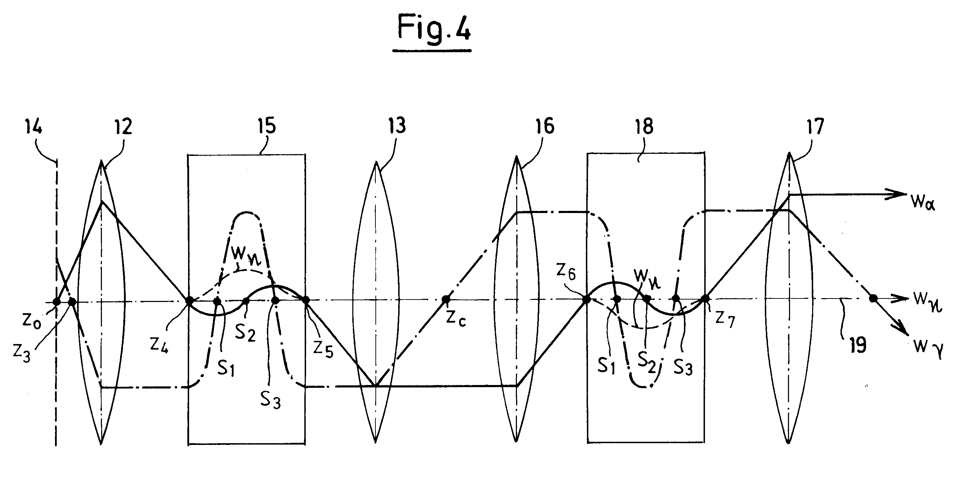

In Fig. 4 ist eine Korrektoranordnung gezeigt, welche sich sowohl für ein Raster- als auch ein Transmissionselektronenmikroskop eignet. Im Prinzip würde auch eine Korrektoranordnung gemäß Fig. 1 sich für ein Transmissionselektronenmikroskop eignen. Da aber die Länge des Quadrupols (6) als Korrekturelement für alle von der Nominalenergie abweichenden Elektronen aus Fig. 1 im allgemeinen wesentlich größer als die Brennweite der Bildübertragungslinse (3) gewählt werden muß, eignet sich die in Fig. 1 dargestellte Anordnung mit einem zusätzlichen elektrischen und magnetischen Quadrupol (6) nur für ein Rasterelektronenmikroskop. Wollte man die Anordnung in einem Transmissionselektronenmikroskop verwenden, wäre es aus Raumgründen nicht mehr möglich, den Quadrupol im Brennpunkt der Bildübertragungslinse (3) zu zentrieren. Dann treten aber bei Vorhandensein des Oktupols große außeraxiale Fehler auf, welche die Anordnung zum Einbau in ein Transmissionselektronenmikroskop ungeeignet werden lassen. Dieses Problem wird mit der Anordnung gemäß Fig. 4 umgangen.

Die in Fig. 4 dargestellte Anordnung eines Korrektors zwischen einer Objektivlinse (12) und einer Bildübertragungslinse (17) besteht aus zwei Korrektoren (15,18) des Typs, der in Fig. 1 beschrieben wurde, und einer "dicken" teleskopischen Rundlinse, welche in Fig. 4 durch zwei Rundlinsen (13,16) (Rundlinsendublett) realisiert wird. Damit die beiden magnetischen Rundlinsen (13,16) zwischen den beiden Korrektoren (15,18) für die Elektronen drehfrei sind, müssen die Stromrichtungen in den beiden Rundlinsen (13,16) entgegengesetzt sein.

Der erste Korrektor (15) befindet sich in der Zwischenbildebene $(Z_4)$ hinter der Objektivlinse (12), d.h. auf der der Objektebene (14) entgegengesetzten Seite der Objektivlinse (12). Der Verlauf der Elektronenbahnen im Inneren des Korrektors (15) entspricht den Verläufen aus Fig. 1. Am Ende des Korrektors (15) befindet sich eine weitere Zwischenbildebene $(Z_5)$. Auf der optischen Achse (19) folgen nun zwei Rundlinsen (13,16), zwischen welchen sich eine Zwischenbildebene $(Z_c)$ befindet. Der zweite Korrektor (18) beginnt nun in der Zwischenbildebene $(Z_6)$ nach diesen beiden Rundlinsen (13,16) und endet an einer weiteren Zwischenbildebene $(Z_7)$ vor der Bildübertragungslinse (17).

Mit der in Fig. 4 dargestellten Anordnung kann der chromatische Fehler und der Öffnungsfehler aller Rundlinsen des Systems für alle Energien der Elektronen sowohl in einem Raster- als auch in einem Transmissionselektronenmikroskop korrigiert werden. Die Korrektoren (15,18) müssen dabei, gemessen zur Kathode, auf einem Potential von ungefähr 5 bis 10 kV liegen.

Das Potential am Objekt kann beliebig gewählt werden, je nachdem ob die Objektivlinse (12) als Beschleunigungs- oder als Verzögerungslinse betrieben wird. Die Bildübertragungslinse (17) kann entweder eine Magnetlinse oder eine elektrische Beschleunigungslinse sein, je nachdem welche Energie die Elektronen in der Bildebene haben sollen. Die Dipol- und Quadrupolfelder der beiden Korrektoren (15,18) sind gleich groß. Die Sextupolfelder hingegen sind unterschiedlich groß und haben entgegengesetzte Vorzeichen. Ihr Wert wird gemäß der Anlage A erst gleich eingestellt und dann während der Feinjustierung optimiert. Diese Feinjustierung ist sowieso notwendig, da die sich aus den errechneten Werten gemäß der Formeln in Anlage A ergebende mögliche Einstellung der Pole nur für eine Grobjustierung ausreicht (theoretische Werteermittlung mit den Formeln aus Anlage A). Allein schon die mechanischen Toleranzen der Fertigung sowie die unterschiedlichen Auswirkungen von den verschiedenen benutzten Materialien bezüglich der Felderzeugung bedingen zwangsläufig eine Feinjustierung. Diese Feinjustierung kann z.B. experimentell anhand von Beugungsfiguren (siehe auch Optik 63, No. 1 (1982), S. 21-23) oder in bekannter Art und Weise anhand von Beugungssäumen von Lochfolien erfolgen.

Die in Fig. 4 beschriebene Korrektionsanordnung kann noch dahingehend verbessert werden, daß nur ein Korrektor vom Wien Typ (20) benötigt wird. Das erlaubt einen einfacheren Betrieb, da nur ein Korrektor vom Wien-Typ (20) hochgelegt und hochstabilisiert sein muß. Diesen Vorteil erhält man dadurch, daß man den Korrektor vom Wien-Typ (20) zwischen zwei Transferlinsen (21,22) anordnet.

Dieser Korrektor (20) beginnt in der bildseitigen Brennebene $(z_{11})$ der ersten Transferlinse (21) und endet in der objektseitigen Brennebene $(z_{12})$ der zweiten Transferlinse (22). Beide Transferlinsen (21,22) müssen identisch im Aufbau und in ihrer Erregung sein.

Der Korrektor vom Wien-Typ (20) wird dabei so erregt, daß er keinen chromatischen Astigmatismus 1. Ordnung erzeugt. Dies wird dadurch erreicht, daß die Bedingungen 1) - 7) in der Anlage A erfüllt werden. Die Bedingung 8) für die Beseitigung der sphärischen Aberration 3. Ordnung ist aber nicht mehr zu erfüllen, wenn das Potential des Objekts beliebig sein soll. Zur Korrektion der sphärischen Aberration dienen zwei gleich starke elektrische oder magnetische Multipole (23,24), die als Hexapole erregt werden.

Der erste dieser Multipole (24) ist im objektseitigen Brennpunkt ($z_{10}$) der ersten Transferlinse (21) zentriert. Der zweite dieser Multipole (23) ist im bildseitigen Brennpunkt ($z_{13}$) der zweiten Transferlinse (22) zentriert. Die Transferlinsen (21,22) sind als schwache Rundlinsen konstruiert. Wenn die Energie der Elektronen vor der ersten Transferlinse (21) nicht im Bereich von 5-10 keV ist, müssen die Transferlinsen (21,22) elektrisch sein. Ist die Energie größer als 5-10 keV, dann wirkt die erste Transferlinse (21) als Verzögerungslinse und die zweite Transferlinse (22) als Beschleunigungslinse. In diesem Fall liegt der Korrektor vom Wien-Typ (20) innerhalb eines Zwischenverzögerers.

Beträgt die Energie vor der ersten Transferlinse (21) zwischen 5 und 10 keV, dann kann man als Transferlinsen (21,22) elektrische oder magnetische Einzellinsen verwenden. Dabei versteht man unter Einzellinsen solche Linsen, welche objekt- und bildseitig das gleiche elektrische Potential haben. Im Falle der Verwendung von magnetischen Transferlinsen müssen die Stromrichtungen in den beiden Linsen entgegengesetzt sein.

Die Geometrie und die Brechkräfte der beiden Transferlinsen (21,22) müssen identisch sein. Der Gesamtkorrektor (25) besteht somit aus zwei gleichen Hexapolen (23,24), zwei gleichen Transferlinsen (21,22) und einem Korrektor vom Wien-Typ (20). Der Gesamtkorrektor (25) ist symmetrisch in Bezug auf seine Mittelebene (26) und zur optischen Achse (31).

Der große Vorteil des hier beschriebenen Gesamtkorrektors (25) besteht darin, daß nur ein Element (20) hochstabil betrieben werden muß (insbesondere dessen Dipol- und Quadrupolfelder). Die Stabilität der Hexapolfelder braucht hingegen nur 1-2 Größenordnungen niedriger zu sein.

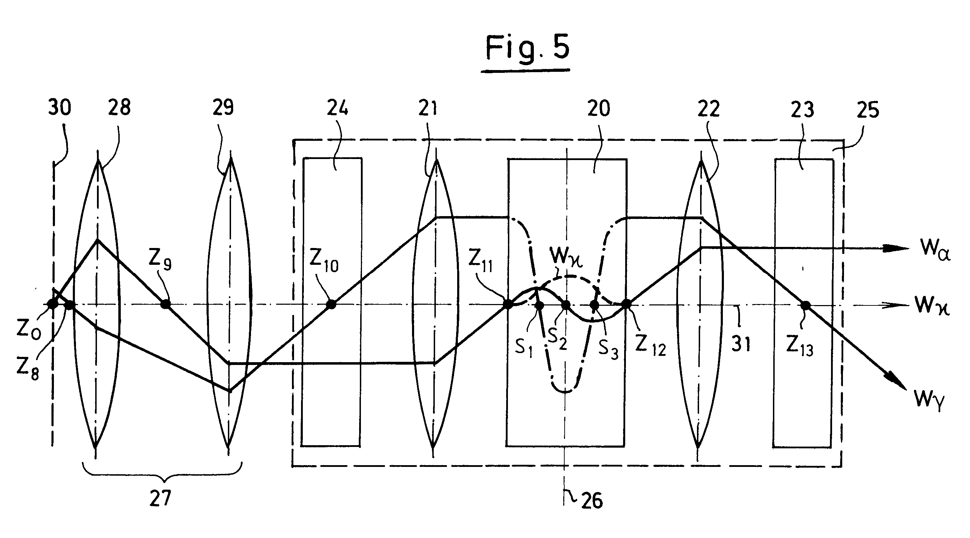

Da der Gesamtkorrektor (25) in einem Transmissionselektronenmikroskop eingebaut ist, das eine hohe Bildpunktzahl haben soll (Bildpunktzahl = Zahl der gleich gut aufgelösten Bildpunkte längs eines Bilddurchmessers), wird eine Objektivdoppellinse (27) benötigt. Diese ist in der Fig. 5 durch die zwei Linsen (28,29) gegeben. Die Verwendung einer solchen Objektivdoppellinse (27) an der Objektebene (30) hat den Vorteil, daß man ihre komafreie Ebene außerhalb des Feldbereichs der Linse (27) legen kann. Dies wird dadurch erreicht, daß man ein Zwischenbild ($Z_9$) ins Innere der Objektivdoppellinse (27) legt. Dadurch, daß man die komafreie Ebene ($Z_{10}$) der Objektivdoppellinse (27) in die Mitte des ersten als Hexapol betriebenen Multipols (24) legt und damit in die objektseitige Brennebene ($Z_{10}$) der ersten Transferlinse (21), erreicht man, daß keine Koma 3. Ordnung im Gesamtsystem auftritt. Außerdem erreicht man, daß diese Brennebene ($Z_{10}$) der ersten Transferlinse (21) gleichzeitig eine komafreie Ebene des Gesamtkorrektors (25) ist und die Komafreiheit der Objektivdoppellinse (27) stetig an den Gesamtkorrektor (25) geführt wird. Der Gesamtkorrektor (25) kann somit auch als elektronenoptischer Aplanat bezeichnet werden.

In den in der Fig. 5 gezeichneten Strahlengängen W liegt das Zwischenbild hinter dem Gesamtkorrektor (25) im Unendlichen. Mit Hilfe der zweiten Linse (29) der Objektivdoppellinse (27) läßt sich die Lage des Zwischenbildes hinter dem Gesamtkorrektor (25) beim Betrieb beliebig einregulieren, ohne daß die Geometrie des Gesamtkorrektors (25) verändert werden muß. Diese Einstellung kann gegebenenfalls eine schwache Nachregulierung der Korrekturfelder notwendig machen.

## ANLAGE A

1) $\phi_1 = v \cdot \psi_1$

2) $\dfrac{\phi_1}{\phi_c} = \dfrac{4\pi\sqrt{2}}{I}$

3) $\phi_2 - v\psi_2 = \dfrac{1}{8}\dfrac{\phi_1^2}{\phi c}$

4) $\phi_3 - v\psi_3 = \dfrac{1}{4}\phi_2\dfrac{\phi_1}{\phi_c} - \dfrac{1}{32}\dfrac{\phi_1^3}{\phi_c^2}$

5) $\phi_4 - v\psi_4 = \dfrac{1}{4}\phi_3\dfrac{\phi_1}{\phi_c} + \dfrac{1}{8}\dfrac{\phi_2^2}{\phi_c} - \dfrac{3}{32}\phi_2\dfrac{\phi_1^2}{\phi_1^2} + \dfrac{5}{512}\dfrac{\phi_1^4}{\phi_c^3}$

6) $\phi_3 = \dfrac{10}{3}\dfrac{\phi_2^2}{\phi_c} - \dfrac{1}{35}\phi_2\dfrac{\phi_1}{\phi_c} - \dfrac{1}{72}\dfrac{\phi_1^3}{\phi_c^2}$

7) $I\left(1 - 4\dfrac{\phi_2\phi_c}{\phi_1^2}\right) = C_{C2} + C_{C1}M^2\left(\dfrac{\phi_c}{\phi_0}\right)^{3/2}$

8)

$$\frac{3}{4}\left[\frac{C_{C2}}{l} + \frac{C_{C1}}{l} M^4 \left(\frac{\phi_c}{\phi_0}\right)^{3/2}\right] + \frac{1}{4} =$$

$$\frac{C_{S2}}{l} + \frac{C_{S1}}{l} M^2 \left(\frac{\phi_c}{\phi_0}\right)^{3/2} + \frac{1}{2}\left[\frac{C_{C2}}{l} + \frac{C_{C1}M^2}{l} \left(\frac{\phi_c}{\phi_0}\right)^{3/2}\right]^2.$$

wobei die genannten Variablen folgende Bedeutung haben:

l-effektive Länge der Multipolfelder

M-Vergrößerung vor dem Wien-Filter

v-Geschwindigkeit der Elektronen

$C_{S1}$-Koeffizient des Öffnungsfehlers der ersten Linse

$C_{S2}$-Koeffizient des Öffnungsfehlers der zweiten Linse

$C_{C1}$-Koeffizient des axialen Farbfehlers der ersten Linse

$C_{C2}$-Koeffizient des axialen Farbfehlers der zweiten Linse

$\phi_0$-elektrisches Normalpotential der Elektronen

$\phi_c$-elektrisches Potential auf der optischen Achse des Wien-Filters

$\phi_1$-elektrischer Dipolkoeffizient des Wien-Filters

$\psi_1$-magnetischer Dipolkoeffizient des Wien-Filters

$\phi_2$-elektrischer Quadrupolkoeffizient des Wien-Filters

$\psi_2$-magnetischer Quadrupolkoeffizient des Wien-Filters

$\phi_3$-elektrischer Hexapolkoeffizient des Wien-Filters

$\psi_3$-magnetischer Hexapolkoeffizient des Wien-Filters

$\phi_4$-elektrischer Oktupolkoeffizient des Wien-Filters

$\psi_4$-magnetischer Oktupolkoeffizient des Wien-Filters

## Patentansprüche

1. Abbildender Korrektor vom Wien-Typ für Elektronen mikroskope mit einer mindestens achtzähligen Anordnung der Elektroden und magnetischen Polen, die zur Erzeugung elektrischer und magnetischer Korrekturfelder dienen, mit mindestens einer Objektiv- und einer Bildübertragungslinse, wobei der Korrektor zwischen einer Objektiv- und einer Bildübertragungslinse angeordnet ist, dadurch gekennzeichnet, daß der Korrektor (1,15,18,20) im eingebauten Zustand an einer Zwischenbildebene ($Z_1$, $Z_3$; $Z_4$, $Z_5$, $Z_6$, $Z_7$ ; $Z_{11}$, $Z_{12}$) beginnt und endet, der Korrektor (1,15,18,20) eine weitere Zwischenbildebene ($S_2$) in seiner Mitte hat und in den Korrektor (1, 15, 20) parallel zur optischen Achse (5,19,31) einfallende Strahlen ($W_\gamma$) bezüglich der mittleren Zwischenbildebene ($S_2$) spiegelsymmetrisch verlaufen, die optische Achse (5,19,31) jeweils zwischen zwei Zwischenbildebenen ($Z_1$, $Z_3$; $Z_4$ , $Z_5$, $Z_6$ , $Z_7$; $Z_{11}$, $Z_{12}$) schneiden und an den Schnittpunkten einen punktsymmetrischen Verlauf innerhalb einer Korrektorhälfte bezogen zur optischen Achse (5,19,31) haben.

2. Abbildender Korrektor nach Anspruch 1, dadurch gekennzeichnet, daß jeder Pol unabhängig von den anderen Polen bezüglich der elektrischen Feldstärke und der magnetischen Erregung einstellbar ist.

3. Abbildender Korrektor nach Anspruch 1 oder 2, dadurch gekennzeichnet, daß die mit M bezeichnete Zwischenvergrößerung des Objektfeldes in der Eintrittsebene ($Z_1$, $Z_4$, $Z_{11}$) des Korrektors (1;15,13,16,18,20) im Bereich $1 \leqq M \leqq 2$ liegt.

4. Abbildender Korrektor nach einem der Ansprüche 1-3, dadurch gekennzeichnet, daß der abbildende Korrektor vom Wien-Typ (20) in der Mitte eines Gesamtkorrektors (25) zwischen zwei Transferlinsen (21,22) in deren inneren Brennpunkten ($Z_{11}$, $Z_{12}$) beginnt und endet, daß zwei hexapolfelderzeugende Multipule (23,24) um die äußeren Brennpunkte der Transferlinsen ($Z_{10}$, $Z_{13}$) zentriert sind, daß der Gesamtkorrektor (25) symmetrisch zur Mittelebene (26) des Korrektors (20) aufgebaut ist und daß der abbildende Korrektor vom Wien-Typ (20) bezüglich seiner Variablen folgende Bedingungen erfüllt

$$\phi_1 = v\psi_1$$

$$\frac{\phi_1}{\phi_c} = \frac{4\Pi\sqrt{2}}{l}$$

$$\phi_2 - v\psi_2 = \frac{1}{8}\frac{\phi_1^2}{\phi_c}$$

$$\phi_3 - v\psi_3 = \frac{1}{4}\phi_2\frac{\phi_1}{\phi_c} - \frac{1}{32}\frac{\phi_1^3}{\phi_c^2}$$

$$\phi_4 - v\psi_4 = \frac{1}{4}\phi_3\frac{\phi_1}{\phi_c} + \frac{1}{8}\frac{\phi_2^2}{\phi_c} - \frac{3}{32}\phi_2\frac{\phi_1^2}{\phi_1^2} + \frac{5}{512}\frac{\phi_1^4}{\phi_c^3}$$

$$\phi_3 = \frac{10}{3}\frac{\phi_2^2}{\phi_c} - \frac{1}{35}\phi_2\frac{\phi_1}{\phi_c} - \frac{1}{72}\frac{\phi_1^3}{\phi_c^2}$$

$$I\left(1 - 4\frac{\phi_2\,\phi_c}{\phi_1^2}\right) = C_{c2} + C_{c1}\,M^2\left(\frac{\phi_c}{\phi_0}\right)^{3/2},$$

wobei

I die effektive Länge der Multipolfelder,

M die Vergrößerung vor dem Wien-Filter,

v die Geschwindigkeit der Elektronen,

$C_{c1}$ die Koeffizienten des axialen Farbfehlers der ersten Linse,

$C_{c2}$ die Koeffizienten des axialen Farbfehlers der zweiten Linse,

$\phi_0$ das elektrische Nominalpotential der Elektronen,

$\phi_c$ das elektrische Potential auf der optischen Achse des Wien-Filters,

$\phi_1$ der elektrische Dipolkoeffizient des Wien-Filters,

$\psi_1$ der magnetische Dipolkoeffizient des Wien-Filters,

$\phi_2$ der elektrische Quadrupolkoeffizient des Wien-Filters,

$\psi_2$ der magnetische Quadrupolkoeffizient des Wien-Filters,

$\phi_3$ der elektrische Hexapolkoeffizient des Wien-Filters,

$\psi_3$ der magnetische Hexapolkoeffizient des Wien-Filters,

$\phi_4$ der elektrische Oktupolkoeffizient des Wien-Filters und

$\psi_4$ der magnetische Oktupolkoeffizient des Wien-Filters ist.

5. Abbildender Korrektor nach einem der Ansprüche 1-4, dadurch gekennzeichnet, daß zwischen Objektebene (27) und Korrektor (1,15,20,25) eine Objektivdoppellinse (27) angebracht ist, deren komafreie Ebene ($Z_{10}$) sich außerhalb des Linsenfeldes im Zentrum des objektseitigen Multipoles (24) des Korrektors (1,15,20,25) befindet.

6. Abbildender Korrektor nach einem der Ansprüche 1-3, dadurch gekennzeichnet, daß der Korrektor (1,15,18) in ein Niedervolt-Rasterelektronenmikroskop eingebaut ist.

7. Abbildender Korrektor nach einem der Ansprüche 1-3 oder 6, dadurch gekennzeichnet, daß die vom Korrektor (1,15,18) erzeugten Quadrupolfelder bezüglich ihrer Variablen folgende Bedingungen erfüllen

$$\phi_1 = v\psi_1$$

$$\frac{\phi_1}{\phi_c} = \frac{4\Pi\sqrt{2}}{I}$$

$$\phi_2 - v\psi_2 = \frac{1}{8}\frac{\phi_1^2}{\phi_c}$$

$$\phi_3 - v\psi_3 = \frac{1}{4}\phi_2\frac{\phi_1}{\phi_c} - \frac{1}{32}\frac{\phi_1^3}{\phi_c^2}$$

$$\phi_4 - v\psi_4 = \frac{1}{4}\phi_3\frac{\phi_1}{\phi_c} + \frac{1}{8}\frac{\phi_2^2}{\phi_c} - \frac{3}{32}\phi_2\frac{\phi_1^2}{\phi_1^2} + \frac{5}{512}\frac{\phi_1^4}{\phi_c^3}$$

$$\phi_3 = \frac{10}{3}\frac{\phi_2^2}{\phi_c} - \frac{1}{35}\phi_2\frac{\phi_1}{\phi_c} - \frac{1}{72}\frac{\phi_1^3}{\phi_c^2}$$

$$I\left(1 - 4\frac{\phi_2\,\phi_c}{\phi_1^2}\right) = C_{c2} + C_{c1}\,M^2\left(\frac{\phi_c}{\phi_0}\right)^{3/2},$$

$$-\frac{3}{4}\left[\frac{C_{c\,2}}{1}+\frac{C_{c\,1}}{1}M^4\left(\frac{\phi_c}{\phi_0}\right)^{3/2}\right]+\frac{1}{4}=$$

$$\frac{C_{s\,2}}{1}+\frac{C_{s\,1}}{1}M^2\left(\frac{\phi_c}{\phi_0}\right)^{3/2}+\frac{1}{2}\left[\frac{C_{c\,2}}{1}+\frac{C_{c\,1}\,M^2}{1}\left(\frac{\phi_c}{\phi_0}\right)^{3/2}\right]^2$$

wobei

I die effektive Länge der Multipolfelder,

M die Vergrößerung vor dem Wien-Filter,

v die Geschwindigkeit der Elektronen,

$C_{s1}$ die Koeffizienten des Öffnungsfehlers der ersten Linse,

$C_{s2}$ die Koeffizienten des öffnungsfehlers der zweiten Linse,

$C_{c1}$ die Koeffizienten des axialen Farbfehlers der ersten Linse,

$C_{c2}$ die Koeffizienten des axialen Farbfehlers der zweiten Linse,

$\phi_0$ das elektrische Nominalpotential der Elektronen,

$\phi_c$ das elektrische Potential auf der optischen Achse des Wien-Filters,

$\phi_1$ der elektrische Dipolkoeffizient des Wien-Filters,

$\psi_1$ der magnetische Dipolkoeffizient des Wien-Filters,

$\phi_2$ der elektrische Quadrupolkoeffizient des Wien-Filters,

$\psi_2$ der magnetische Quadrupolkoeffizient des Wien-Filters,

$\phi_3$ der elektrische Hexapolkoeffizient des Wien-Filters,

$\psi_4$ der magnetische Hexapolkoeffizient des Wien-Filters,

$\phi_4$ der elektrische Oktupolkoeffizient des Wien-Filters und

$\psi_4$ der magnetische Oktupolkoeffizient des Wien-Filters ist.

**8.** Abbildender Korrektor nach einem der Ansprüche 1-7, dadurch gekennzeichnet, daß die Länge des Korrektors vom Wien-Typ (1,15,18,20) zwischen 40mm und 60mm bei einem Bohrungsradius von 2-5 mm liegt.

**9.** Abbildender Korrektor nach einem der Ansprüche 7-8, dadurch gekennzeichnet, daß ein elektrischer und magnetischer Quadrupol (6) hinter der ersten, in Strahlrichtung auf den Korrektor (1) folgenden Bildübertragungslinse (3) in deren hinteren Brennebene (8) angebracht ist.

**10.** Abbildender Korrektor nach einem der Ansprüche 1-9, dadurch gekennzeichnet, daß hinter dem ersten Korrektor (15) ein zweiter identischer Korrektor (18) auf der optischen Achse (19) angebracht ist, daß zwischen den beiden Korrektoren (15,18) ein Rundlinsendublette (13,16) angebracht ist und daß sich in der Mitte des Rundlinsendubletts (13,16) eine Zwischenbildebene ($Z_c$) befindet.

**11.** Abbildender Korrektor nach Anspruch 10, dadurch gekennzeichnet, daß der Korrektor (13,15,16,18;20) in einem Transmissionselektronenmikroskop eingebaut ist.

## Claims

**1.** Imaging corrector of the Wien type for an electron microscope having an at least eight-fold arrangement of the electrodes and magnetic poles for generating electrical and magnetical correction fields, having at least one objective lens and one image transfer lens, whereby the corrector is arranged between an objective lens and an image transfer lens, characterized by the fact that the forward and rearward ends of the corrector (1, 15, 18, 20), if installed, are disposed within an intermediate image plane ($Z_1$, $Z_3$; $Z_4$, $Z_5$, $Z_6$, $Z_7$; $Z_{11}$, $Z_{12}$), that the corrector 1, 15, 18, 20) provides at least an additional intermediate image plane

($S_2$) in its centre and that electron rays ($W_y$) entering the corrector (1, 15, 20) parallel to the optical axis (5, 19, 31) trace a path through the corrector which is mirror symmetrical with respect to the additional intermediate image plane ($S_2$), intersects the optical axis (5, 19, 31) ones between each two intermediate image planes ($Z_1$, $Z_3$; $Z_4$, $Z_5$, $Z_6$, $Z_7$; $Z_{11}$, $Z_{12}$) and trace a path at the intersection points which is point symmetrical with respect to the optical axis (5, 19, 31) within an half of the corrector.

2. Imaging corrector of claim 1, characterized by the fact that each of the poles is adjustable independently of the remaining poles with respect to electrical field strength and magnetical excitation.

3. Imaging corrector of claims 1 or 2, characterized by the fact that the intermediate magnification of the object field within the entry plane ($Z_1$, $Z_4$, $Z_{11}$) of the corrector (1; 15, 13, 16, 18, 20), being designated by M, lies in the range of $1 \leqq M \leqq 2$.

4. Imaging corrector of one of the claims 1-3, characterized by the fact that the imaging corrector of the Wien type (20) starts and ends within the centre of a total corrector (25) between two image transfer lenses (21, 22) and within their internal focal points ($Z_{11}$, $Z_{12}$), that two multipoles (23, 24) generating hexapole fields are centred around the outer focal points ($Z_{10}$, $Z_{13}$) of the transfer lenses (21, 22), that the total corrector (25) is arranged symmetrically to the centre plane (26) of the corrector (20) and that the imaging corrector of the Wien type (20) fulfils the following conditions with respect to its parameters:

$$\Phi_1 = v \cdot \psi_1$$

$$\frac{\Phi_1}{\Phi_c} = \frac{4\pi\sqrt{2}}{l}$$

$$\Phi_2 - v\psi_2 = \frac{1}{8}\frac{\Phi_1^2}{\Phi_c}$$

$$\Phi_3 - v\psi_3 = \frac{1}{4}\Phi_2\frac{\Phi_1}{\Phi_c} - \frac{1}{32}\frac{\Phi_1^3}{\Phi_c^2}$$

$$\Phi_4 - v\psi_4 = \frac{1}{4}\Phi_3\frac{\Phi_1}{\Phi_c} + \frac{1}{8}\frac{\Phi_2^2}{\Phi_c} - \frac{3}{32}\Phi_2\frac{\Phi_1^2}{\Phi_1^2} + \frac{5}{512}\frac{\Phi_1^4}{\Phi_c^3}$$

$$\Phi_3 = \frac{10}{3}\frac{\Phi_2^2}{\Phi_c} - \frac{1}{35}\Phi_2\frac{\Phi_1}{\Phi_c} - \frac{1}{72}\frac{\Phi_1^3}{\Phi_c^2}$$

$$l\left(1 - 4\frac{\Phi_2\Phi_c}{\Phi_1^2}\right) = C_{C2} + C_{C1}M^2\left(\frac{\Phi_c}{\Phi_0}\right)^{3/2}$$

whereby is:

$l$ - effective length of the multipole fields
M - magnification ahead of the Wien filter
v - velocity of the electrons
$C_{C1}$ - coefficient of the axial chromatic aberration of the first lens

$C_{C2}$ - coefficient of the axial chromatic aberration of the second lens

$\Phi_0$ - electrical nominal potential of the electrons
$\Phi_c$ - electrical potential on the optical axis of the Wien filter
$\Phi_1$ - electrical dipole coefficient of the Wien filter
$\psi_1$ - magnetic dipole coefficient of the Wien filter
$\Phi_2$ - electrical quadrupole coefficient of the Wien filter
$\psi_2$ - magnetic quadrupole coefficient of the Wien filter
$\Phi_3$ - electrical hexapole coefficient of the Wien filter
$\psi_3$ - magnetic hexapole coefficient of the Wien filter
$\Phi_4$ - electrical octupole coefficient of the Wien filter
$\psi_4$ - magnetic octupole coefficient of the Wien filter

5. Imaging corrector of one of the claims 1-4, characterized by the fact that a double objective lens (27) is arranged between the object plane (27) and the corrector (1, 15, 20, 25) which double objective lens has a coma-free plane ($Z_{10}$) outside of the lens field within the centre of the object-sided multipole (24) of the corrector (1, 15, 20, 25).

6. Imaging corrector of one of the claims 1-3, characterized by the fact that the corrector (1, 15, 18) is arranged within a low-energy scanning electron microscope.

7. Imaging corrector of one of the claims 1-3 or 6, characterized by the fact that the quadrupole fields generated by the corrector (1, 15, 18) with respect to their parameters fulfil the following conditions:

$$\Phi_1 = v \cdot \psi_1$$

$$\frac{\Phi_1}{\Phi_c} = \frac{4\pi\sqrt{2}}{l}$$

$$\Phi_2 - v\psi_2 = \frac{1}{8}\frac{\Phi_1^2}{\Phi_c}$$

$$\Phi_3 - v\psi_3 = \frac{1}{4}\Phi_2\frac{\Phi_1}{\Phi_c} - \frac{1}{32}\frac{\Phi_1^3}{\Phi_c^2}$$

$$\Phi_4 - v\psi_4 = \frac{1}{4}\Phi_3\frac{\Phi_1}{\Phi_c} + \frac{1}{8}\frac{\Phi_2^2}{\Phi_c} - \frac{3}{32}\Phi_2\frac{\Phi_1^2}{\Phi_1^2} + \frac{5}{512}\frac{\Phi_1^4}{\Phi_c^3}$$

$$\Phi_3 = \frac{10}{3}\frac{\Phi_2^2}{\Phi_c} - \frac{1}{35}\Phi_2\frac{\Phi_1}{\Phi_c} - \frac{1}{72}\frac{\Phi_1^3}{\Phi_c^2}$$

$$l\left(1 - 4\frac{\Phi_2\Phi_c}{\Phi_1^2}\right) = C_{C2} + C_{C1}M^2\left(\frac{\Phi_c}{\Phi_0}\right)^{3/2}$$

$$\frac{3}{4}\left[\frac{C_{C2}}{l} + \frac{C_{C1}}{l}M^4\left(\frac{\Phi_c}{\Phi_0}\right)^{3/2}\right] + \frac{1}{4} =$$

$$\frac{C_{S2}}{l} + \frac{C_{S1}}{l}M^2\left(\frac{\Phi_c}{\Phi_0}\right)^{3/2} + \frac{1}{2}\left[\frac{C_{C2}}{l} + \frac{C_{C1}M^2}{l}\left(\frac{\Phi_c}{\Phi_0}\right)^{3/2}\right]^2$$

wherein is:

| | |
|---|---|
| $l$ - | effective length of the multipole fields |
| $M$ - | magnification ahead of the Wien filter |
| $v$ - | velocity of the electrons |
| $C_{S1}$- | coefficient of the spherical aberration of the first lens |
| $C_{S2}$- | coefficient of the spherical aberration of the second lens |
| $C_{C1}$ - | coefficient of the axial chromatic aberration of the first lens |
| $C_{C2}$ - | coefficient of the axial chromatic aberration of the second lens |
| $\Phi_0$ - | electrical normal potential of the electrons |
| $\Phi_c$- | electrical potential on the optical axis of the Wien filter |
| $\Phi_1$ - | electrical dipole coefficient of the Wien filter |
| $\psi_1$ - | magnetic dipole coefficient of the Wien filter |
| $\Phi_2$ - | electrical quadrupole coefficient of the Wien filter |
| $\psi_2$ - | magnetic quadrupole coefficient of the Wien filter |
| $\Phi_3$ - | electrical hexapole coefficient of the Wien filter |
| $\psi_3$ - | magnetic hexapole coefficient of the Wien filter |
| $\Phi_4$ - | electrical octupole coefficient of the Wien filter |
| $\psi_4$ - | magnetic octupole coefficient of the Wien filter |

8. Imaging corrector of one of the claims 1-7, characterized by the fact that the length of the corrector of the Wien type (1, 15, 18, 20) is in the range of 40mm to 60mm and has a bore radius in the range of 2mm to 5mm.

9. Imaging corrector of one of the claims 7 or 8, characterized by the fact that an electrical and magnetical quadrupole (6) is arranged behind, and within the back focal plane (8) of, the first image transfer lens (3) following the corrector (1) in the beam direction.

10. Imaging corrector of one of the claims 1-9, characterized by the fact that following to the first corrector (15) a second identical corrector (18) is arranged along the optical axis (19), that a round lens doubled (13, 16) is arranged between both correctors (15, 18) and that an intermediate image plane ($Z_c$) is generated in the centre of the round lens doubled (13, 16).

11. Imaging corrector of claim 10, characterized by the fact that the corrector (13, 15, 16, 18; 20) is arranged in a transmission electron microscope.

**Revendications**

1. Correcteur reproducteur selon Wien pour microscopes électroniques offrant une structure d'au moins huit électrodes et pôles magnétiques servant à générer des champs de correction électriques et magnétiques et disposé entre au moins une lentille d'objectif et une lentille de transmission d'image, caractérisé en ce que les plans d'entrée et de sortie du correcteur incorporé (1, 15, 18, 20) coïncident avec des plans d'image intermédiaires ($Z_1$, $Z_3$; $Z_4$, $Z_5$, $Z_6$, $Z_7$; $Z_{11}$, $Z_{12}$), que le correcteur (1, 15, 18, 20) a en son centre un autre plan d'image intermédiaire ($S_2$) et que les faisceaux d'électrons ($W_\gamma$) pénétrant dans le correcteur (1, 15, 20) parallèlement à l'axe optique (5, 19, 31) évoluent selon une symétrie spéculaire par rapport au plan d'image intermédiaire médian ($S_2$), coupent l'axe optique (5, 19, 31) respectivement entre deux plans d'image intermédiaire ($Z_1$, $Z_3$; $Z_4$, $Z_5$, $Z_6$, $Z_7$; $Z_{11}$, $Z_{12}$) et présentent dans les points d'intersection dans chaque moitié du correcteur une symétrie ponctuelle par rapport à l'axe optique (5, 19, 31).

2. Correcteur reproducteur selon la revendication 1, caractérisé en ce que chaque pôle est réglable indépendamment des autres pôles quant à l'intensité de champ électrique et à l'excitation magnétique.

3. Correcteur reproducteur selon la revendication 1 ou 2, caractérisé en ce que l'agrandissement intermédiaire du champ d'objet dans le plan d'entrée ($Z_1$, $Z_4$, $Z_{11}$) du correcteur (1; 15, 13, 16, 18, 20), désigné par la lettre M, est comprise dans la plage $1 \leqq M \leqq 2$.

4. Correcteur reproducteur selon l'une quelconque des revendications 1 à 3, caractérisé en ce que le correcteur reproducteur selon Wien (20) est placé au centre d'un correcteur d'ensemble (25), entre deux lentilles de transfert (21, 22) dont les points focaux intérieurs ($Z_{11}$, $Z_{12}$) marquent respectivement son entrée et sa sortie, que deux multipôles (23, 24) générant des champs hexapolaires sont centrés autour des points focaux extérieurs desdites lentilles de transfert ($Z_{10}$, $Z_{13}$), que le correcteur d'ensemble (25) est structuré symétriquement par rapport au plan médian (26) du correcteur (20) et que les variables du correcteur reproducteur selon Wien (20) remplissent les conditions suivantes:

$$\Phi_1 = v \cdot \psi_1$$

$$\frac{\Phi_1}{\Phi_c} = \frac{4\pi\sqrt{2}}{l}$$

$$\Phi_2 - v\psi_2 = \frac{1}{8}\frac{\Phi_1^2}{\Phi_c}$$

$$\Phi_3 - v\psi_3 = \frac{1}{4}\Phi_2\frac{\Phi_1}{\Phi_c} - \frac{1}{32}\frac{\Phi_1^3}{\Phi_c^2}$$

$$\Phi_4 - v\psi_4 = \frac{1}{4}\Phi_3\frac{\Phi_1}{\Phi_c} + \frac{1}{8}\frac{\Phi_2^2}{\Phi_c} - \frac{3}{32}\Phi_2\frac{\Phi_1^2}{\Phi_1^2} + \frac{5}{512}\frac{\Phi_1^4}{\Phi_c^3}$$

$$\Phi_3 = \frac{10}{3}\frac{\Phi_2^2}{\Phi_c} - \frac{1}{35}\Phi_2\frac{\Phi_1}{\Phi_c} - \frac{1}{72}\frac{\Phi_1^3}{\Phi_c^2}$$

$$l\left(1 - 4\frac{\Phi_2\Phi_c}{\Phi_1^2}\right) = C_{C2} + C_{C1}M^2\left(\frac{\Phi_c}{\Phi_0}\right)^{3/2}$$

où

l est la longueur effective des champs multipolaires,

M l'agrandissement avant le filtre de Wien,

v la vitesse des électrons,

$C_{c1}$ les coefficients de l'aberration chromatique axiale de la première lentille,

$C_{c2}$ les coefficients de l'aberration chromatique axiale de la seconde lentille,

$\Phi_0$ le potentiel électrique nominal des électrons,

$\Phi_c$ le potentiel électrique sur l'axe optique du filtre de Wien,

$\Phi_1$ le coefficient dipolaire électrique du filtre de Wien,

$\Psi_1$ le coefficient dipolaire magnétique du filtre de Wien,

$\Phi_2$ le coefficient quadripolaire électrique du filtre de Wien,

$\Psi_2$ le coefficient quadripolaire magnétique du filtre de Wien,

$\Phi_3$ le coefficient hexapolaire électrique du filtre de Wien,

$\Psi_3$ le coefficient hexapolaire magnétique du filtre de Wien,

$\Phi_4$ le coefficient octopolaire électrique du filtre de Wien

et

$\psi_4$ le coefficient octopolaire magnétique du filtre de Wien.

5. Correcteur reproducteur selon l'une quelconque des revendications 1 à 4, caractérisé en ce qu'un doublet formant objectif (27) disposé entre le plan d'objet (30) et le correcteur (1, 15, 20, 25) présente un plan exempt de coma ($Z_{10}$) qui se trouve en dehors du champ de lentille, au centre du multipôle côté objet (24) du correcteur (1, 15, 20, 25).

6. Correcteur reproducteur selon l'une quelconque des revendications 1 à 3, caractérisé en ce que le correcteur (1, 15, 18) est incorporé à un microscope électronique à balayage fonctionnant à basse tension.

7. Correcteur reproducteur selon l'une quelconque des revendications 1 à 3 ou 6, caractérisé en ce que les variables des champs quadripolaires générés par le correcteur (1, 15, 18) remplissent les conditions suivantes:

$$\Phi_1 = v \cdot \psi_1$$

$$\frac{\Phi_1}{\Phi_c} = \frac{4\pi\sqrt{2}}{l}$$

$$\Phi_2 - v\psi_2 = \frac{1}{8}\frac{\Phi_1^2}{\Phi_c}$$

$$\Phi_3 - v\psi_3 = \frac{1}{4}\Phi_2\frac{\Phi_1}{\Phi_c} - \frac{1}{32}\frac{\Phi_1^3}{\Phi_c^2}$$

$$\Phi_4 - v\psi_4 = \frac{1}{4}\Phi_3\frac{\Phi_1}{\Phi_c} + \frac{1}{8}\frac{\Phi_2^2}{\Phi_c} - \frac{3}{32}\Phi_2\frac{\Phi_1^2}{\Phi_1^2} + \frac{5}{512}\frac{\Phi_1^4}{\Phi_c^3}$$

$$\Phi_3 = \frac{10}{3}\frac{\Phi_2^2}{\Phi_c} - \frac{1}{35}\Phi_2\frac{\Phi_1}{\Phi_c} - \frac{1}{72}\frac{\Phi_1^3}{\Phi_c^2}$$

$$l\left(1 - 4\frac{\Phi_2\Phi_c}{\Phi_1^2}\right) = C_{C2} + C_{C1}M^2\left(\frac{\Phi_c}{\Phi_0}\right)^{3/2}$$

$$\frac{3}{4}\left[\frac{C_{C2}}{l} + \frac{C_{C1}}{l}M^4\left(\frac{\Phi_c}{\Phi_0}\right)^{3/2}\right] + \frac{1}{4} =$$

$$\frac{C_{S2}}{l} + \frac{C_{S1}}{l}M^2\left(\frac{\Phi_c}{\Phi_0}\right)^{3/2} + \frac{1}{2}\left[\frac{C_{C2}}{l} + \frac{C_{C1}M^2}{l}\left(\frac{\Phi_c}{\Phi_0}\right)^{3/2}\right]^2$$

où

l est la longueur effective des champs multipolaires,

M l'agrandissement avant le filtre de Wien,

v la vitesse des électrons,

$C_{s1}$ les coefficients de l'aberration sphérique de la première lentille,

$C_{s2}$ les coefficients de l'aberration sphérique de la seconde lentille,

$C_{c1}$ les coefficients de l'aberration chromatique axiale de la première lentille,

$C_{c2}$ les coefficients de l'aberration chromatique axiale de la seconde lentille,

$\Phi_0$ le potentiel électrique nominal des électrons,

$\Phi_c$ le potentiel électrique sur l'axe optique du filtre de Wien, $\Phi_1$ le coefficient dipolaire électrique du filtre de Wien,

$\Psi_1$ le coefficient dipolaire magnétique du filtre de Wien,

$\Phi_2$ le coefficient quadripolaire électrique du filtre de Wien,

$\Psi_2$ le coefficient quadripolaire magnétique du filtre de Wien,

$\Phi_3$ le coefficient hexapolaire électrique du filtre de Wien,

$\Psi_3$ le coefficient hexapolaire magnétique du filtre de Wien,

$\Phi_4$ le coefficient octopolaire électrique du filtre de Wien

et

$\Psi_4$ le coefficient octopolaire magnétique du filtre de Wien.

8. Correcteur reproducteur selon l'une quelconque des revendications 1 à 7, caractérisé en ce que la longueur du correcteur selon Wien (1, 15, 18, 20) est comprise entre 40 mm et 60 mm pour un diamètre de l'alésage central de 2-5 mm.

9. Correcteur reproducteur selon l'une quelconque des revendications 7 à 8, caractérisé en ce qu'un quadripôle électrique et magnétique (6) est disposé en aval de la première lentille de transmission d'image (3) suivant au correcteur (1) dans le sens du faisceau, dans le plan focal postérieur (8) de celle-ci.

10. Correcteur reproducteur selon l'une quelconque des revendications 1 à 9, caractérisé en ce que le premier correcteur (15) est suivi d'un second correcteur identique (18) disposé sur l'axe optique (19), qu'un doublet de lentilles circulaires (13,16) est aménagé entre lesdits correcteurs (15, 18) et qu'un plan d'image intermédiaire ($Z_c$) se trouve au centre dudit doublet (13,16).

11. Correcteur reproducteur selon la revendication 10, caractérisé en ce que le correcteur (13, 15, 16, 18, 20) est incorporé à un microscope électronique à transmission.

Fig. 1

# Fig. 2

11

10

9b

8a

7  8  9  7a

EP 0 373 399 B1

17

Fig. 3

# Fig.4

EP 0 373 399 B1

# Fig. 5

EP 0 373 399 B1